# EUROPEAN PATENT APPLICATION

(11) **EP 2 184 779 A2**
(43) Date of publication of application: **12.05.2010**
(21) Application number: 09174432.6
(22) Date of filing: 29.10.2009
(51) Int. Cl.: H01L 27/15, H01L 33/00

(54) **Light-Emitting Module and Illumination Device**

(30) Priority: 07.11.2008 JP 2008286213; 15.09.2009 JP 2009213633
(71) Applicant: Toshiba Lighting & Technology Corporation, Yokosuka-shi Kanagawa 237-8510 (JP)
(72) Inventor: Ogawa, Kozo, Yokosuka-shi Kanagawa (JP); Nishimura, Kiyoshi, Yokosuka-shi Kanagawa (JP)
(74) Representative: Shindler, Nigel

(57) **Abstract**

There is provided a light-emitting module which makes it difficult to sense glare and which suppresses the temperature rise of light-emitting diode chips and has a cost advantage. The light-emitting module is provided with a base body (11) formed with a non-metallic member having a thermal conductivity of 1 W/mk or less. In the base body, a plurality of LED chips are spaced 10 to 30 mm apart from each other, and their junction temperature when they are normally lit is preferably set at 90°C or less. A translucent sealing member covering an area between the adjacent light-emitting diode chips is provided.

## Description

### FIELD OF THE INVENTION

The present invention relates to a light-emitting module and an illumination device that have a light-emitting diode as a light source.

### BACKGROUND OF THE INVENTION

In recent years, since light-emitting diodes have been enhanced in light emission efficiency, they have become commercially available and have been adopted as light sources for relatively large illumination devices such as for offices and general illumination. In these illumination devices, a COB (chip on board) module in which a plurality of light-emitting diodes can be arranged close to each other is often used.

For example, in Japanese Laid-Open Patent Publication No. 2004-95655, there are disclosed an illumination device directly fitted to a ceiling and a hanging illumination device in which, on a base body formed substantially in the shape of a plane, a light-emitting module (COB module) where a plurality of light-emitting diodes are arranged in a matrix is provided, and in which this light-emitting module is used as a light source. In Japanese Laid-Open Patent Publication No. 2007-294621, there is disclosed an illumination device in which, a plurality of light-emitting diode chips are arranged on a metallic base body, and in which the light-emitting diode chips are covered with sealing material such that they are closely spaced 2 mm or 1.2 mm apart from each other. In Japanese Laid-Open Patent Publication No. 2008-117538, there is also disclosed an illumination device in which, in order to prevent the generation of glare, light-emitting diode chips are closely spaced 5 to 10 mm apart from each other.

In these illumination devices, in order to obtain a large amount of light from one COB module used as a light source body of the device, it is necessary to closely mount light-emitting diode chips. For example, Japanese Laid-Open Patent Publication No. 2007-294621 indicates that the light-emitting diode chips are closely spaced 2 mm or 1.2 mm apart from each other.

Disadvantageously, however, since the brightness of a light-emitting diode is relatively high, when light-emitting diodes are closely arranged, the brightness of a module as a whole is high, with the result that glare is highly likely to be generated. In recent years, as the brightness and the output of a light-emitting diode have been increasingly raised, it is likely to further suffer from glare. Thus, when, in the configuration of a relatively large illumination device, such as for a facility like an office, that provides overall illumination from a ceiling, high-density COB modules are distributed over a wide area, they act as independent light sources, and variations in brightness and glare are generated; in order to prevent this, a light diffusing plate having high diffusivity is provided, with the result that the efficiency of an apparatus is disadvantageously lowered.

Also, when light-emitting diodes are closely arranged, the temperature of the light-emitting diodes is significantly increased, and thus the life of the light-emitting diodes is shortened; when other mounted components and mounted components are mounted with solder, effects resulting from melting, deterioration and the like of the solder are produced. Thus, since a conventional COB module needs to sufficiently acquire heat dissipation, it uses a base body made of expensive metal such as aluminum, with the result that, when the COB module is used as a light source for a relatively large illumination device, disadvantageously, its cost is significantly increased.

Although Japanese Laid-Open Patent Publication No. 2008-117538 discloses that, in a COB module, in order for the generation of glare to be suppressed, light-emitting diode chips are spaced 5 to 10 mm apart from each other, even if light-emitting diodes are closely arranged within the range of this space, since the temperature of the light-emitting diodes is likely to be significantly increased, it is necessary to acquire heat dissipation performance and it is necessary to use a metallic board, with the result that its cost is disadvantageously increased.

To overcome the foregoing disadvantage, the present invention has been designed and has an object to provide a light-emitting module and an illumination device which makes it difficult to sense glare and which reduces the temperature rise of light-emitting diode chips and has a cost advantage.

### SUMMARY OF THE INVENTION

According to one aspect of the present invention, there is provided a light-emitting module including: a base body formed with a non-metallic member having a thermal conductivity of 1W/mk or less; a plurality of light-emitting diode chips spaced 10 to 30 mm apart from each other in a front surface of the base body, an electric power of 0.06 to 0.10 W being supplied to each of the chips; and a translucent sealing member covering an area between the adjacent light-emitting diode chips.

With the light-emitting module of the present invention, the uses of the base body formed with a non-metallic member having a thermal conductivity of 1 W/mk or less, a plurality of light-emitting diode chips spaced 10 to 30 mm apart from each other in the front surface of the base body and the translucent sealing member covering an area between the adjacent light-emitting diode chips make it possible not only to prevent glare and variations in brightness which makes it difficult to sense glare but also to suppress, without using, as the base body, expensive aluminum or the like having satisfactory thermal conductivity, the temperature rise of light-emitting diode chips even if using a base body such as glass epoxy or the like having low thermal conductivity but being relatively inexpensive. Thus, it is possible to configure the light-emitting module, even when it is normally lit, so that it is unlikely that the temperature of the light-emitting diode chips becomes high and which has a long life and a cost advantage.

The light-emitting module of the present invention is preferably applied to a relatively large illumination device such as for offices in which overall illumination from a ceiling or the like is provided and for facility/commercial purposes, and may be applied to a small illumination device for general illumination in houses or the like.

The base body is a member for arranging the light-emitting diode chips serving as a light source. In order to configure the light-emitting module which makes it difficult to sense glare and which suppresses the temperature rise of the light-emitting diodes and has a cost advantage, it is permissible to form the base body with a nonmetallic member, such as a glass epoxy material, a paper phenol material or a glass composite, that has low thermal conductivity but is relatively inexpensive, as compared with an expensive metal, such as aluminum, that has satisfactory thermal conductivity. The base body may be formed of ceramic as long as it has a cost advantage. Although the base body is preferably formed in the shape of a square or a rectangle in which a planar module is provided that is required for a plurality of light-emitting diode chips to be spaced a predetermined distance apart from each other, the base body may be formed in the shape of a polygon such as a hexagon, a circle or an oval, or may be formed in a long line into a linear module. Any shape is permissible so that intended light distribution characteristics are obtained. Although a wiring pattern is formed on the base body, and the light-emitting diode chips are preferably mounted on the wiring pattern, means such as for configuring and mounting the base body is not limited to any specific one.

Although the light-emitting diode chips are preferably arranged partially or as a whole on the base body in a matrix, for example, by COB (chip on board) technology, any arrangement is permissible as long as they are arranged partially or as a whole in a regular and constant order such as a staggered arrangement or a radial arrangement. Although the overall shape of the arranged light-emitting diode chips is preferably an approximate square, any shape such as a rectangle, a polygon, a circle or an oval is permissible as long as the light-emitting diode chips serving as a light source can be effectively arranged and intended light distribution is achieved.

If the space between the light-emitting diode chips is less than 10 mm, the junction temperature of the light-emitting diode chips when they are normally lit is likely to be increased. When the junction temperature is increased, the life of the light-emitting diode chips is shortened, and, when other mounted components and mounted components are mounted with solder, effects resulting from melting, deterioration and the like of the solder are produced. If the space between the light-emitting diode chips is more than 30 mm, the size of the light-emitting module is increased, and, when the light-emitting module is viewed, the light-emitting diode chips appear granular, and they appear as point light sources, with the result that variations in brightness are likely to be sensed. Thus, the space between the light-emitting diode chips preferably falls within a range of 10 to 30 mm.

The space between the light-emitting diode chips is a distance between the center of one of the light-emitting diode chips arranged in a regular and constant order partially or as a whole and the center of the adjacent light-emitting diode chip, but it does not mean a strict distance between the centers, and an approximate distance between the centers including measurement errors permitted in terms of design is permissible.

Preferably, the junction temperature of the light-emitting diode chips is set at 90°C or less. Thus, the temperature of the light-emitting diode chips is unlikely to be high, and hence the life thereof is not significantly lowered; even when solder is used in a board on which the light-emitting diode chips are mounted, the solder is not melted by effects resulting from the heat generation of the light-emitting diode chips; and, since other mounted components are unlikely to be affected by heat, failures are unlikely to occur. The junction temperature of the light-emitting diode chips, for example, refers to the temperature of a junction surface between a P-type semiconductor and an N-type semiconductor that constitute the light-emitting diode chip; the value of the temperature does not need to be obtained by directly measuring the temperature of the junction surface, and the value may be calculated from temperatures in the vicinity of the chips or the like. The junction temperature can optionally be set as a temperature of a portion other than the junction surface; it is defined to acquire the characteristics of the light-emitting diode chips.

The sealing member is provided to cover both the light-emitting diode chips and the areas between the adjacent light-emitting diode chips; although the sealing member is preferably formed of, for example, a transparent or semi-transparent translucent resin such as a silicon resin, an epoxy resin or the like, for example, a layer may be used that is obtained by mixing and distributing a predetermined yellow fluorescent substance or the like. In the front surface of the sealing member, separate light controlling means such as a front surface cover and a lens body for controlling an optical path may be additionally provided.

In addition, the light-emitting module of the present invention applies to a COB module in which a plurality of light-emitting diode chips are arranged at the front surface of the base body and in which the light-emitting diode chips are covered with the sealing member but does not apply to a module such as an SMD (surface mounting device) module, other than the COB module, in which the light-emitting diode chips are accommodated in the recessed portion of a container and in which the sealing resin is filled to be sealed.

In addition, the base body of the light-emitting module of the present invention is provided with a reflector between the light-emitting diode chips that reflects light emitted from the light-emitting diode chips in the direction of the front surface; the reflector is covered with the translucent sealing member.

Since the base body of the light-emitting module of the present invention is provided with the reflector between the light-emitting diode chips that makes light emitted from the light-emitting diode chips reflect in the direction of the front surface, it is possible to configure the light-emitting module that further reduces variations in brightness. Since the amount of sealing member can be reduced, it is possible to further reduce the cost.

Since the reflector is provided between the adjacent light-emitting diode chips and makes light emitted laterally from the light-emitting diode chips reflect in the direction of the front surface and thus it is unlikely to cause variations in brightness, the reflector is preferably provided so as to correspond to each of the light-emitting diode chips. However, the reflector may be provided in the light-emitting diode chips selected as appropriate for necessary portions. A plurality of reflectors may all have the same reflective function, or may be a combination of different reflective functions. One common reflector may be provided for a plurality of light-emitting diode chips.

As the material of the reflector, in consideration of the light reflective function, white synthetic resin having light resistance, heat resistance and electrical insulation, for example, PBT (polybutylene terephthalate) or synthetic resin such as acrylic resin or ABS is used; the reflectors may be integrally formed. In addition, their surface may be coated such that it has white color, metal such as aluminum or silver may be deposited, or plating or the like may be performed to provide a mirror surface or a semi-mirror surface processing. The reflector is formed of metal such as aluminum, and, as in the above-described synthetic resin, white coating, evaporation, plating or the like may be performed.

Although, preferably, the reflectors are formed of, for example, synthetic resin, a plurality of reflectors are integrally formed with a sprue runner that is inevitably formed when it is formed of resin and a plurality of reflectors are arranged simultaneously at a time between the light-emitting diode chips on the base body, the reflectors may be individually arranged by an automated machine. The means for the formation and the means for the arrangement on the base body are not limited to specific means.

Also, on the front surface side of the sealing member, the light-emitting module of the present invention is provided with a translucent front surface cover without an air layer being interposed between the sealing member and the front surface cover.

Since, on the front surface side of the sealing member, the light-emitting module of the present invention is provided with the front surface cover without an air layer being interposed between the sealing member and the front surface cover, heat from the light-emitting diode chips is conducted through the front surface cover, and thus thermal conductivity is enhanced, with the result that the heat dissipation from the front surface is enhanced and the temperature rise of the light-emitting diode chips can be suppressed.

As the front surface cover, for example, a molding formed of translucent synthetic resin is arranged in close contact with the front surface of the sealing member or a translucent filling resin having the same material as the molding is filled between the molding and the sealing member and is arranged without an air layer being interposed between the sealing member and the front surface cover. By applying or filling the translucent synthetic resin to cover the entire front surface of the light-emitting module and thus achieving an integrated formation, it is possible to arrange the front surface cover between the sealing member and the front surface without an air layer being interposed. The front surface cover may be a lens or the like that has an optical action.

According to another aspect of the present invention, there is provided an illumination device including: the light-emitting module; an apparatus main body provided with the light-emitting module; and a lighting device lighting the light-emitting module.

According to the aspect of the present invention, there is provided an illumination device which makes it difficult to sense glare and which has a long life and a cost advantage.

Although, in the present invention, the illumination device preferably forms a relatively long, large illumination apparatus in combination with a plurality of light-emitting modules such as for offices and facilities/commercial purposes, a small illumination apparatus for general illumination such as for houses may be formed with one light-emitting module.

Although the apparatus main body is preferably formed of metal, such as a steel plate, a stainless steel or aluminum, that has satisfactory thermal conductivity, for example, it may be formed of synthetic resin, such as PBT (polybutylene terephthalate), that has heat resistance, light resistance and electrical insulation.

The lighting device, for example, may be formed with a lighting circuit that converts an alternating-current voltage of 100 volts into a direct-current voltage of 24 volts and that supplies it to the light-emitting diode chips, or may be incorporated into the apparatus main body or may be arranged separately of the apparatus main body.

### BRIEF DESCRIPTION OF THE DRAWINGS

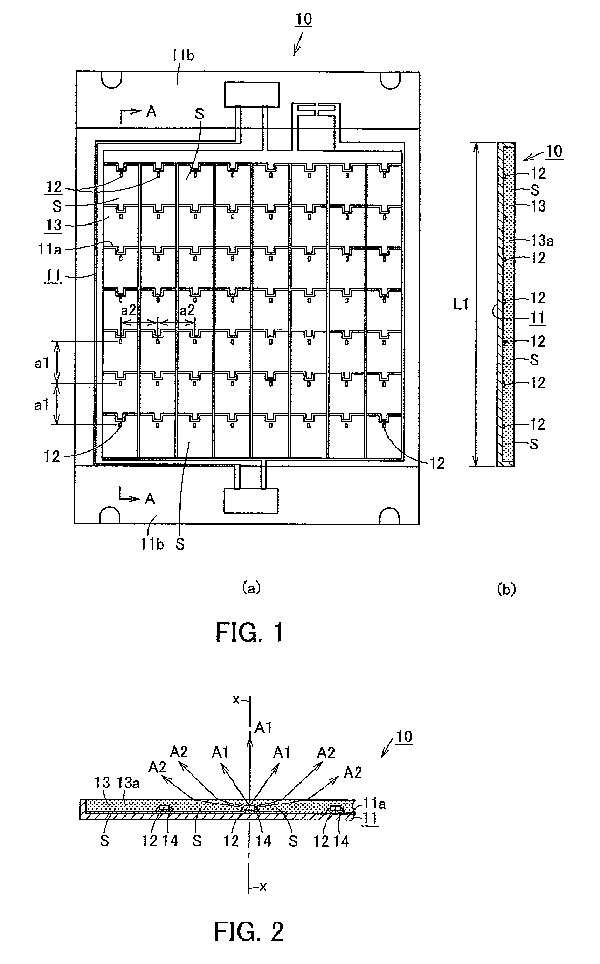

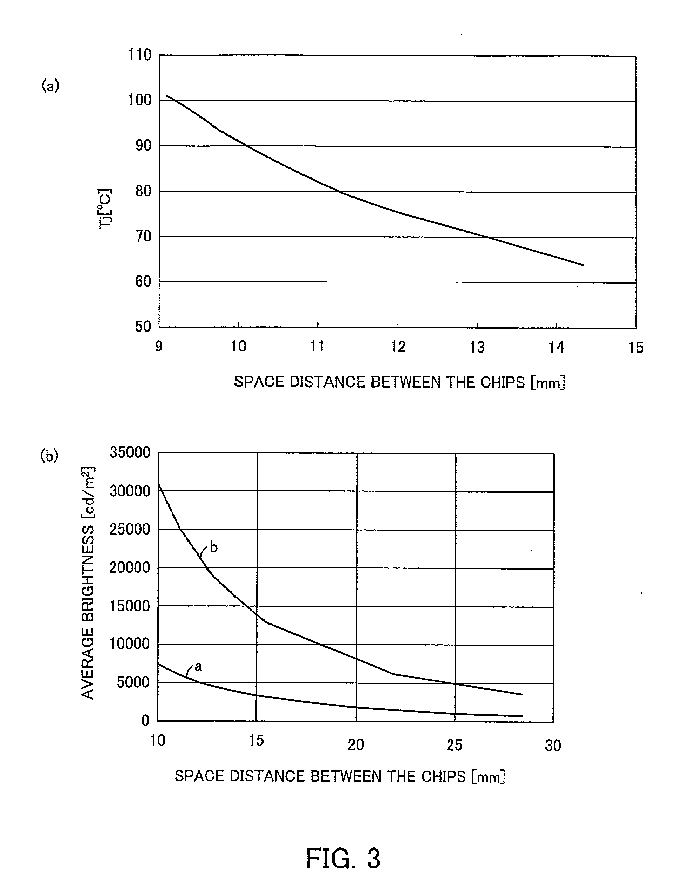

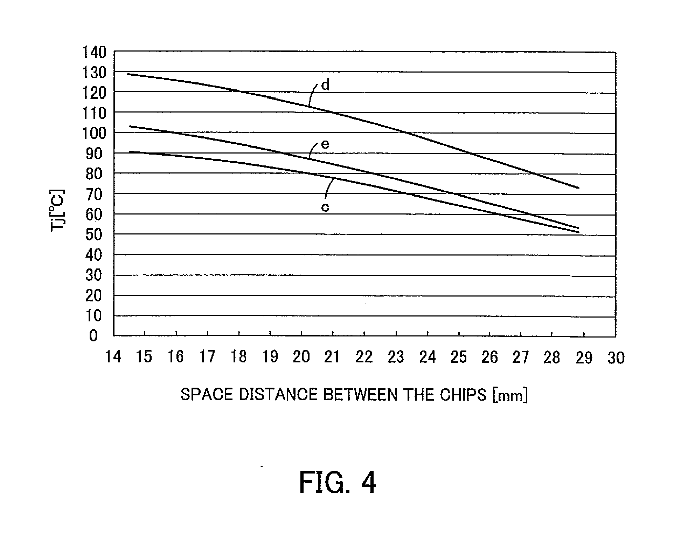

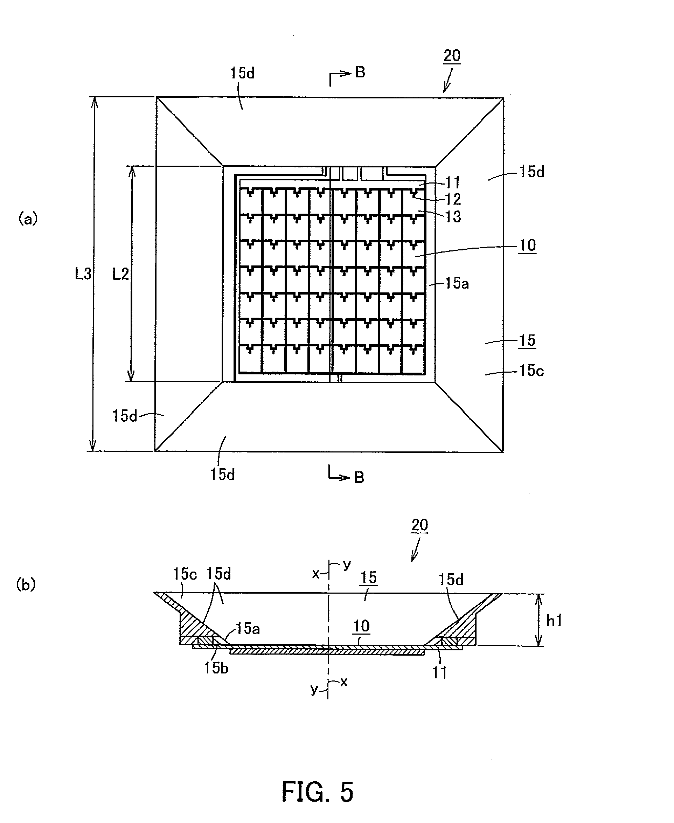

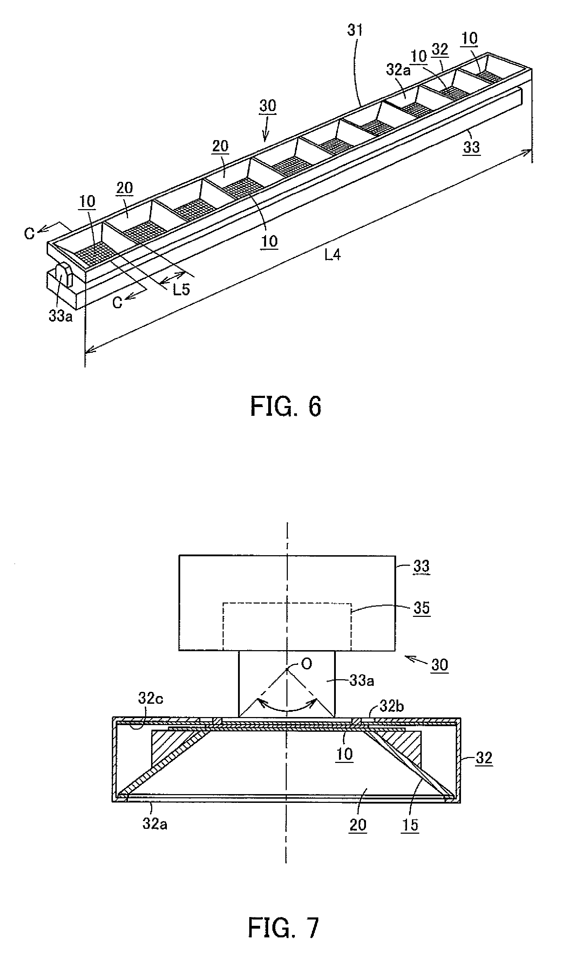

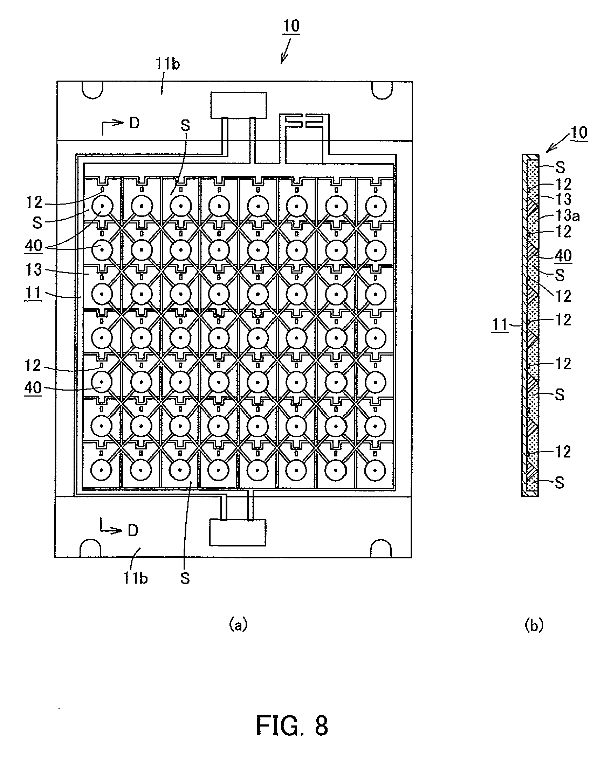

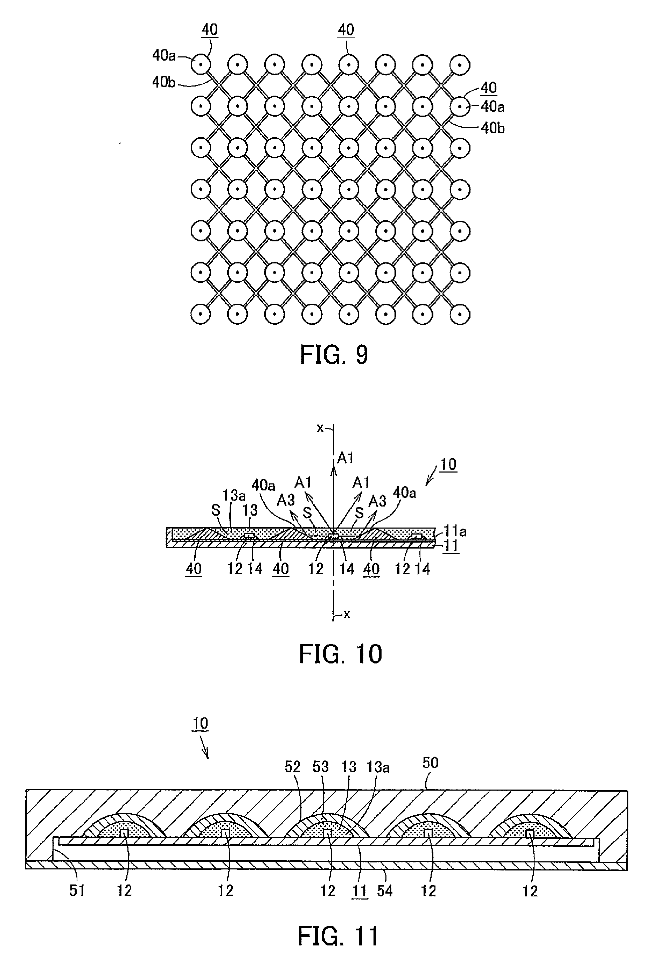

Figs. 1 (a) and 1 (b) show an embodiment of a light-emitting module according to the present invention, and Fig. 1 (a) is a front view of the light-emitting module, and Fig. 1 (b) is a cross-sectional view of the light-emitting module taken along line A-A of Fig. 1 (a); Fig. 2 is an enlarged cross-sectional view of the light-emitting module; Figs. 3(a) and 3(b) show the results of a test performed on the light-emitting module, and Fig. 3(a) is a graph showing the relationship between a chip space and junction temperature, and Fig. 3(b) is a graph showing the relationship between the chip space and an average brightness; Fig. 4 shows the results of a test performed on the light-emitting module, and is a graph showing the relationship between the chip space and the junction temperature; Figs. 5(a) and 5(b) show a light-emitting device using the light-emitting module, and Fig. 5(a) is a front view of the light-emitting device, and Fig. 5(b) is a cross-sectional view of the light-emitting device taken along line B-B of Fig. 5(a); Fig. 6 is a perspective view of an illumination device using the light-emitting module; Fig. 7 is an inverted cross-sectional view taken along line C-C of Fig. 6; Fig. 8 shows a modified example of the light-emitting module, and Fig. 8(a) is a front view of the light-emitting module, and Fig. 8(b) is a cross-sectional view of the light-emitting module taken along line D-D of Fig. 8(a); Fig. 9 is a front view of a reflector used in the modified example of the light-emitting module; Fig. 10 is an enlarged cross-sectional view of the modified example of the light-emitting module; and Fig. 11 is a cross-sectional view showing another modified example of the light-emitting module.

### DETAILED DESCRIPTION OF THE PREFERRED EMBODIMENT

Embodiments of a light-emitting module and an illumination device using this light-emitting module according to the present invention will be described below.

The configuration of a light-emitting module 10 will first be described with reference to Figs. 1(a), 1(b) and 2. The light-emitting module 10 is composed of a base body 11, light-emitting diode chips 12 (hereinafter referred to as LED chips) arranged on the base body 11 and a translucent sealing member 13 covering the light-emitting diode chips 12.

The base body 11 is a non-metallic member that is used for the LED chips 12 to be arranged and that has a thermal conductivity of 1 W/mk or less, and is formed of, for example, a glass epoxy member and is formed with a substantially square flat plate. In the front surface of the base body 11, a wiring pattern 11a made of copper foil is formed, and a plurality of LED chips 12 are adhesively fixed on the wiring pattern 11a with an adhesive 14.

As the LED chips 12, a plurality of LED chips 12 having the same function are prepared. In this embodiment, each LED chip 12 is formed with a high-brightness and high-output blue LED chip.

In the base body 11 and the LED chips 12, with a COB (chip on board) technology, a plurality of LED chips 12 are mounted in a matrix on the wiring pattern 11a of the base body 11; the base body 11 and the LED chips 12 constitute the light-emitting module 10, the appearance of which is shaped substantially in the form of a square.

A plurality of LED chips 12 are loosely spaced. Specifically, in this embodiment, in the base body 11 formed substantially in the shape of a square the width L1 of one side of which is approximately 100 mm, a total of 56 LED chips 12, 7 in a vertical direction and 8 in a horizontal direction, are spaced 10 to 30 mm apart from each other such that a space dimension a1 between the LED chips 12 in a vertical direction in Fig. 1 is approximately 14 mm, and that a space dimension a2 between the LED chips 12 in a horizontal direction is approximately 12 mm. As shown in Fig. 1, the space dimensions a1 and a2 refer to distances between the center of the LED chip 12 and the center of the adjacent LED chip 12. The LED chips 12 regularly spaced in a matrix with the space dimensions a1 and a2 therebetween are electrically connected in series by the wiring pattern 11a. The reference numeral 11 b in the figure represents a supporting portion formed integrally at both ends of the base body 11, and the supporting portion is a member that supports the base body 11 to a frame 15 which will be described later.

In the front surface of the light-emitting module 10, the sealing member 13 having translucency is filled. Specifically, the sealing member 13 is obtained by mixing a yellow fluorescent substance 13a with transparent silicon resin, and is applied or filled over the front surface of the base body 11 such that the LED chips 12, the wiring pattern 11a and the like are included and embedded in the sealing member 13. In this way, areas around the embedded LED chips 12 and spaces S formed between the adjacent LED chips 12 are covered with the layers of the sealing member 13 obtained by mixing and distributing the yellow fluorescent substance 13a with and in the transparent silicon resin, and thus the LED chips 12 are sealed in the front surface of the base body 11. In this embodiment, since each LED chip 12 is formed with the blue LED chip, the yellow fluorescent substance 13a is excited by blue light emitted from this blue LED chip and thus yellow light is emitted, with the result that white light is emitted from the front surface of the sealing member 13. That is, the outer shape of the light-emitting module 10 is formed substantially in the shape of a square with a light axis x-x (see Fig. 2) along which the white light is emitted.

Thus, in order for a light-emitting module which makes it difficult to sense glare and which suppresses the temperature rise of light-emitting diode chips 12 and has a cost advantage to be provided, a plurality of LED chips 12 are preferably arranged 10 to 30 mm apart from each other on the base body 11, and more preferably, a junction temperature in a normal lit condition is equal to or less than 90°C.

These space dimensions and junction temperature were determined by performing the following test. First, as the base body 11, with a glass epoxy board that has a thermal conductivity lower than aluminum but is relatively inexpensive, COB modules having a light-emitting portion approximately 100 mm x 100 mm were prepared; when 10 of these COB modules were arranged in a line 100 mm apart from each other, and they were combined with an aluminum enclosure approximately 100 mm in width, approximately 1000 mm in length and approximately 20 mm in height, the junction temperature Tj of the LED chips 12 in a normal lit condition was measured and the results are shown in Fig. 3(a), and the average brightness of an apparatus and the average brightness of the module were measured and the results are shown in Fig. 3(b). Here, the normal lit condition, for example, refers to a condition in which an ambient temperature is not in an abnormal condition, which is not a use condition that cannot be imagined and which is a use condition allowable (imagined) for use in these light-emitting modules 10.

At that time, the measurement conditions were that a glass epoxy board having a thermal conductivity of 0.4 W/mk was used as the base body 11, copper having a thermal conductivity of 383 W/mk was used as the wiring pattern 11a, the adhesive 14 with which the LED chips 12 were bonded to the base body 11 had a thermal conductivity of 0.2 W/mk, sapphire serving as the base of the LED chips 12 had a thermal conductivity of 46 W/mk, the sealing member 13 had a thermal conductivity of 0.2 W/mk, an atmosphere temperature was 35°C and an input current to one chip was 30 mA (0.10W).

In Fig. 3(a), the horizontal axis represents the pitch distance between the LED chips 12, and the vertical axis represents the junction temperature Tj. If the junction temperature Tj of the LED chips 12 is higher than 90°C, the life of the LED chips 12 is shortened, and, when other mounted components and mounted components are mounted with solder, effects resulting from melting, deterioration and the like of the solder are produced; thus, the junction temperature Tj is preferably equal to or less than 90°C. Fig. 3(a) shows that, in order for the junction temperature Tj to be equal to or less than 90°C, the space dimension of the LED chips 12 needs to be approximately 10 mm or above.

In Fig. 3(b), the horizontal axis represents the pitch distance between the LED chips 12, and the vertical axis represents the average brightness, and a graph "a" represents the average brightness of the apparatus and a graph "b" represents the average brightness of the module. The graph "a" shows that, when the space dimension is equal to or more than 10 mm, the average brightness of the apparatus is a brightness at which glare is not sensed, that is, a BCD (between comfort and discomfort) brightness, and, specifically, it is equal to or less than a brightness of 10000 cd/m² at which uncomfortable glare starts to be sensed. When the brightness is equal to or less than 10000 cd/m², the brightness is approximately equal to that of an illumination device using an ordinary fluorescent lamp, with the result that glare is not sensed.

In addition, if the input current for one chip is decreased, it is possible to narrow the space dimension of the LED chips 12, whereas, if it is increased, it is possible to widen the space dimension. Also, if a heat dissipation area of an illumination device is increased and thus the junction temperature Tj is decreased, the space dimension of the LED chips 12 can be narrowed; however, in this case, since, when, for example, the illumination device is directly fitted to the surface of a ceiling, the dissipation conditions are difficult to satisfy, it is necessary to widen the space dimension.

In consideration of these factors, when a COB module is provided that uses an inexpensive glass epoxy material as the base body 11 and that is used for a relatively large illumination, the space dimension of the LED chips 12 is set at 10 mm or above, and thus the junction temperature in a normal lit condition is equal to or less than 90°C, and the brightness can be equal to or less than 10000 cd/m².

In, for example, a configuration of an illumination device, on the front surface side of the light-emitting module 10, a front surface cover may be placed to cover the front surface of the light-emitting module 10. There are two ways to place the front surface cover on the front surface of the light-emitting module 10; one way is to place the front surface cover such that an air layer is interposed between the front surface cover and the sealing member 13, and the other way is to place it such that an air layer is not interposed between the front surface cover and the sealing member 13. Thus, the junction temperature Tj of the LED chips 12 in a normal lit condition was measured under the three different conditions: without the front surface cover; with the front surface cover and the air layer; and with the front surface cover but without the air layer, and the results are shown in Fig. 4. The measurement conditions were the same as described above.

In Fig. 4, the horizontal axis represents the pitch distance between the LED chips 12, and the vertical axis represents the junction temperature Tj. A graph "c" is obtained without the front surface cover; a graph "d" is obtained with the front surface cover and the air layer; and a graph "e" is obtained with the front surface cover but without the air layer. The graph "d" shows that the junction temperature Tj obtained with the front surface cover and the air layer is higher than those of the other graphs "c" and "d"; in order for the junction temperature Tj to be 90°C or less, the space dimension between the LED chips 12 needs to be approximately 25.5 mm or above.

However, if the space dimension of the LED chips 12 is larger than 30 mm, the number of beams per unit area is reduced, and they are distributed over a large area, with the result that the size of the base body 11 is increased. Thus, it is necessary not only to increase the number of LED chips 12 used but also to further increase the base body 11, and this causes the size of an illumination device to be increased. The LED chips 12 substantially function as a point light source to individually and independently emit light, and thus the LED chips 12 appear granular, resulting in variations in brightness and glare.

As described above, the light-emitting module 10 is configured such that the LED chips 12 are spaced 10 to 30 mm apart from each other and that, in this embodiment, the space dimension a1 between the LED chips 12 in a vertical direction is approximately 14 mm and the space dimension a2 between the LED chips 12 in a horizontal direction is approximately 12 mm. When this light-emitting module 10 is lit, since the space dimensions are not less than 10 mm both in a vertical direction and in a horizontal direction and thus the LED chips 12 are not located close to each other, with the result that the number of beams per unit area is not increased excessively and hence the average brightness is not increased. For this reason, the brightness does not exceed the BCD brightness, that is, a brightness of 10000 cd/m² at which uncomfortable glare starts to be sensed, and thus the generation of glare is prevented, a predetermined amount of brightness is maintained which makes it difficult to sense glare.

Also, since the LED chips 12 are not located close to each other, it is possible to keep the junction temperature of the LED chips 12 at 90°C or less. Thus, it is unnecessary to use, as the base body 11, aluminum, which has satisfactory thermal conductivity but is expensive; even if a glass epoxy material, which has low thermal conductivity but is relatively inexpensive, is used, it is possible to suppress the temperature rise of the LED chips 12, with the result that it is possible to configure light-emitting module 10 having a cost advantage.

Also, since the space dimensions of the LED chips 12 do not exceed 30 mm both in a vertical direction and in a horizontal direction, the number of beams per unit area does not decrease, and thus it is unnecessary to increase the number of the LED chips 12 used, with the result that the size of an illumination device is prevented from being increased. In addition, although the LED chips 12 emit light like dots, it is unlikely that they appear granular, and thus variations in brightness are prevented. Consequently, the entire front surface of the light-emitting module 10 can act as a planar light-emitting portion, which makes it difficult to sense glare.

Since the translucent sealing member 13 is provided to cover the area between the LED chip 12 and the adjacent LED chip 12, as shown in Fig. 2, blue light rays emitted from the front surface of the LED chips 12 travel in the light axis x-x, pass through the sealing member 13 and excite the yellow fluorescent substance 13a mixed and dispersed with and in the sealing member 13 to emit yellow light, and white light A1 is emitted from the front surface of the sealing member 13. Moreover, light A2 that travels sideways from the side surfaces of the LED chips 12 travels toward the space S between the LED chips 12 and excites the yellow fluorescent substance 13a mixed and dispersed with and in the sealing member 13 within this space S to emit yellow light, with the result that the white light A2 is also emitted from the front surface in the position of the space S in the sealing member 13. These light rays A1 and A2 are mixed and emitted, and thus the entire light-emitting module 10 including the space S emits white light. Hence, it is highly unlikely that the LED chips 12 appear granular, and this prevents variations in brightness, with the result that, since the above-described space dimensions a1 and a2 also prevent variations in brightness, it is furthermore possible to make the light-emitting module 10 serve as a planar light source to emit light such that it is difficult to sense glare as a whole.

As shown in Fig. 5, the light-emitting module 10 configured as described above is combined, as necessary, with the frame 15, and thus they constitute the illumination device 20. Although, in this embodiment, the illumination device 20 is composed of the light-emitting module 10 and the frame 15, as long as the light-emitting module 10 is used, the light-emitting module 10 may be configured without the use of the frame 15.

The frame 15 is formed of white synthetic resin having translucency, heat resistance and electrical insulation, and, in this embodiment, is formed of PBT (polybutylene terephthalate) as a rectangular tube-shaped case member having opening portions at both ends and a center axis y-y. In the frame 15, a neck portion 15b having an opening portion at one end 15a substantially in the form of a square, an opening portion at the other end 15c substantially in the form of a square and four inclined surfaces 15d therearound continuous from the opening portion at one end 15a to the opening portion at the other end 15c are integrally formed.

The opening portion at one end 15a in the neck portion 15b is formed substantially in the shape of a square such as to include the light-emitting module 10 substantially formed in the shape of a square. The inclined surface 15d is formed from the opening portion at one end 15a formed substantially in the shape of a square to the opening portion at the other end 15c such that the horizontal cross-section of the inclined surface 15d is substantially shaped in a square.

In the frame 15, the front surface of the base body 11 of the light-emitting module 10 is placed to face the inner surface of the opening portion at one end 15a and is fixed by applying, between the front surface and the sides of the base body 11, an adhesive made of silicon resin, epoxy resin or the like having electrical insulation and thermal conductivity. Thus, the light-emitting module 10 is arranged to face the opening portion at one end 15a, is thermally coupled therewith and is fixed, with the result that the illumination device 20 in which the light axis x-x of the light-emitting module 10 substantially coincides with the center axis y-y of the frame 15 is configured.

In the illumination device 20 of this embodiment, the opening portion at one end 15a of the frame 15 is formed in the shape of a square with an opening dimension L2 of approximately 100 mm x 100 mm, the opening portion at the other end 15c is formed substantially in the shape of a square with an opening dimension L3 of approximately 200 mm x 200 mm and a height dimension h1 (the depth dimension of the inclined surface 15d) is approximately 20 mm.

This illumination device 20 is used alone or a plurality of illumination devices 20 are used in combination, and thus an illumination device is formed that has various functions and a light output.

As shown in Figs. 6 and 7, in this embodiment, ten illumination devices 20 incorporating the light-emitting module 10 are used to constitute an illumination device 30 for use in a facility such as an office.

The illumination device 30 is provided with: the illumination devices 20 incorporating the light-emitting module 10; an apparatus main body 31 in which the illumination devices 20 are provided; and a lighting device 35 that lights the illumination device 30.

The apparatus main body 31 is provided with a main body case 32 that is relatively long and large enough to form an illumination device for use in a facility such as an office and an apparatus base 33 that supports the main body case 32. The main body case 32 is formed with a long frame member with a front surface opening portion 32a at the front surface and a rear surface opening portion 32b at the rear surface, and is formed by bending a coated steel plate. The length dimension L4 of the front surface opening portion 32a is approximately 2000 mm; ten square illumination devices 20 approximately 200 mm by 200 mm configured as described above are arranged and provided in a line along its longitudinal direction.

In this way, the approximately 100 mm wide light-emitting modules 10 are provided via the approximately 100 mm wide frames 15 (the width dimension of one frame 15 - 50mm x 2 pieces = 100 mm) adjacently arranged on both sides thereof. In other words, the light-emitting modules 10 with a space dimension L5 of approximately 100 mm therebetween are arranged in the longitudinal direction of the main body case 32. In addition, ten light-emitting modules 10 in the illumination devices 20 are wiring-connected in series.

The ten illumination devices 20 are arranged in a line along the longitudinal direction on a long steel plate supporting plate 32c, and the bottom surface of the base body 11 is fixed to the supporting plate 32c by fixing means such as a screw. The supporting plate 32c to which the illumination devices 20 are fixed is fixed to the main body case 32 by means such as spot welding such that its rear surface opening portion 32b is closed. In this way, the base body 11 of the light-emitting module 10 and the main body case 32 are thermally coupled with each other via the supporting plate 32c, and the ten illumination devices 20 are continuously provided in a line in the front surface opening portion 32a of the main body case 32 and are regularly spaced in the longitudinal direction.

As with the main body case 32, the apparatus base 33 is formed with a long case of a coated steel plate; on its upper surface of both end portions, pivot portions 33a are formed to protrude therefrom, and both ends of the main body case 32 are pivoted on the pivot portions 33a. In this way, as indicated by arrows in Fig. 7, the main body case 32 is supported such that it can pivot about an axis O within a predetermined angular range. Also, on the rear surface of the apparatus base 33, a supporting portion (not shown) is formed through which the illumination device 30 is fitted to a fitting location such as a ceiling. The lighting device 35 is incorporated into the apparatus base 33.

The lighting device 35 is formed with a lighting circuit (not shown) that converts an alternating-current voltage of 100 volts into a direct-current voltage of 24 volts and that supplies the direct-current voltage to the LED chips 12; the output lead wires of the lighting circuit are let out, via the pivot portions 33a, into the main body case 32, and are connected to the input terminal of the light-emitting modules 10, which are wiring-connected in series with each other, with the result that the illumination device 30 is configured.

The illumination device 30 alone or a plurality of illumination devices 30 are connected and arranged through transmission cables to a fitting location such as a ceiling. When the arranged illumination device 30 is lit, all 560 (56 x 10 = 560) LED chips 12 arranged in the ten light-emitting modules 10 emit light, and the light emitted from the LED chips 12 is emitted through the frame 15 from the front surface opening portion 32a of the main body case 32.

In the illumination device 30 arranged on the ceiling, ten illumination devices 20 are arranged in the longitudinal direction; they constitute a long planar light source approximately 2000 mm in length in which ten 200 mm by 200 mm square planar light sources are continuously arranged in the longitudinal direction of the apparatus main body 31. For example, the illumination device 30 emits light laterally along desks or the like arranged within an office.

Here, since, as described previously, in each of the light-emitting modules 10, the LED chips 12 are spaced on the base body 11 approximately 14 mm vertically and approximately 12 mm horizontally apart from each other, the average brightness of the illumination device 30 as a whole does not exceed a brightness of 10000 cd/m² at which uncomfortable glare starts to be sensed, with the result that the generation of glare is prevented, a predetermined amount of brightness is maintained which makes it difficult to sense glare. At the same time, since it is unlikely that the LED chips 12 appear granular, and thus variations in brightness are prevented, the LED chips 12 can emit light as a long planar light source which makes it difficult to sense glare as a whole.

With respect to heat generated from the LED chips 12, since the LED chips 12 are not located close to each other, the junction temperature of the LED chips 12 can be suppressed to 90°C or less, and heat is dissipated via the supporting plate 32c from the rear surface opening portion 32b of the main body case 32 and is further dissipated from the main body case 32, which is thermally connected to the supporting plate 32c.

Thus, it is unnecessary for the frame 15 having the light-emitting modules 10 fitted thereto to constitute the illumination device 20 to have the function of dissipating heat. This makes it possible not only to form the frame 15 of inexpensive synthetic resin without the use of metal such as aluminum having satisfactory thermal conductivity but being expensive but also to provide the illumination device 20 having a cost advantage, with the result that the illumination device 30 incorporating the illumination device 20 has a cost advantage.

Since the light-emitting module 10 is used alone or a plurality of light-emitting modules 10 are used in combination, various functions and a light output can be achieved, an illumination device that has various light distribution properties and that is used in a facility such as an office can be configured and the illumination device 30 which makes it difficult to sense glare and which suppresses the temperature rise of light-emitting diode chips 12 and has a cost advantage can be provided. Even if a large number of light-emitting modules 10, that is, ten light-emitting modules are used to constitute the illumination device 30, it is possible not only to reduce the amount of heat generated from the entire device but also to dissipate the heat generated by the LED chips 12 via the supporting plate 32c from the base body 11 of the light-emitting module 10, both from the rear surface opening portion 32b of the main body case 32 and from the main body case 32, which is thermally connected to the supporting plate 32c, with the result that it is possible to dissipate the heat effectively and efficiently.

In this way, it is possible to suppress the temperature rise of the LED chips 12 to provide the illumination device 30 that can achieve a long life of the LED chips 12. Moreover, since the light-emitting modules 10 are linearly spaced the space distance L5 - in this embodiment, approximately 100 mm - apart from each other in the longitudinal direction of the main body case 32, it is possible to prevent the adjacent light-emitting modules 10 from thermally interfering with each other, with the result that it is possible to dissipate heat further effectively.

Since the LED chips 12 are mounted on the base body 11 in a matrix by COB technology to constitute the light-emitting module 10 that is formed substantially in the shape of a square as an outer shape, for example, even if the specifications of the LED chips 12 are changed and the number of light beams emitted from one of the LED chips 12 is increased, it is possible to easily configure, by selecting, as appropriate, the arrangement space of the LED chips 12 from the range of 10 to 30 mm to arrange the LED chips 12, the desired light-emitting module and the desired illumination device which makes it difficult to sense glare. Furthermore, it is possible to easily achieve intended light distribution properties only by changing the arrangement of the light-emitting modules 10, for example, by arranging four light-emitting modules 10 such that they are formed substantially in the form of a square.

Although, in this embodiment, the translucent sealing member 13 is provided to cover the area between the LED chip 12 and the adjacent LED chip 12, the space S between the LED chips 12 is made to emit light and thus the planar light source is achieved, in order for the space S to more effectively emit light to prevent variations in brightness, as shown in Fig. 8, reflectors 40 may be provided between the adjacent LED chips 12 such that the reflectors 40 are covered with the translucent sealing member 13.

The reflectors 40 are provided between the adjacent LED chips 12 mounted on the base body 11, and reflect light emitted laterally from the LED chips 12 in the direction of the light axis x-x; the reflector is formed with a conical body that has an inclined surface 40a on its whole circumference with its horizontal cross-sectional view formed substantially in the shape of a circle. The total of 56 reflectors 40 are formed such that they are individually provided in all the 56 spaces S between the LED chips 12.

As the material of the reflectors 40, in consideration of the light reflective performance, white synthetic resin having light resistance, heat resistance and electrical insulation - in this embodiment, PBT (polybutylene terephthalate)- is used; 56 reflectors 40 are integrally formed. Furthermore, in order to enhance the reflective performance, metal such as aluminum or silver is deposited or plating or the like is performed to provide a mirror surface or a semi-mirror surface processing.

As shown in Fig. 9, when 56 reflectors 40 are integrally formed of resin, they are integrally formed with a plurality of reflectors 40 being all coupled by a sprue runner 40b that is inevitably formed; 56 reflectors 40 that are coupled by the sprue runner 40b are all arranged simultaneously at one time at a predetermined position in the space S on the base body 11. Then, as in the light-emitting module 10, with the reflectors 40 arranged, the sealing member 13 is applied or filled over the front surface of the reflectors 40 to fix the reflectors 40 to the base body 11, with the result that the light-emitting module 10 is configured.

When this light-emitting module 10 is lit, as shown in Fig. 10, blue light rays that travel laterally from the side surfaces of the LED chip 12 travel toward the spaces S between the LED chips 12, and are reflected off the inclined surfaces 40a of the reflectors 40 to travel substantially in the direction of the light axis x-x. The blue light rays passing through the sealing member 13 in the space S excite the yellow fluorescent substance 13a mixed and dispersed with and in the sealing member 13 to emit yellow light, and white light A3 is emitted from the front surface of the space S of the sealing member 13. The white light A1 emitted from the front surface of the sealing member 13 is mixed with the light A3 and the resulting light is emitted in the direction of the above-described light axis x-x, and thus the entire front surface of the light-emitting module 10 emits white light to much further function as a planar light source. Consequently, it is highly unlikely that they appear granular and thus variations in brightness are prevented, and the entire front surface of the light-emitting module 10 appears as a planar light-emitting portion, which makes it even more difficult to sense glare.

Since the reflectors 40 are provided in the space S, and the conical reflectors 40 and sprue runner 40b are embedded in the space S, the amount of the sealing member 13 that is formed of expensive silicon resin or fluorescent material and that is applied or filled is reduced and thus a cost advantage is achieved.

Moreover, since, when the reflectors 40 are integrally formed of resin, 56 reflectors 40 can be arranged simultaneously at one time with the reflectors 40 being coupled by the sprue runner 40b that is inevitably formed, it is possible to simplify the fitting work. Furthermore, since, in order for 56 reflectors 40 to be formed integrally, the sprue runner 40b that is inevitably produced when the resin is formed can be utilized, it is unnecessary to perform special working or the like and thus a cost advantage is achieved. Since the sprue runner 40b can be utilized as a tab that is used when the fitting is performed, the operation is much further facilitated. When metal such as aluminum is deposited on the surface of the reflectors 40, the sprue runner 40b can be used as an evaporation jig such as a tab, and thus it is possible to facilitate the evaporation operation. When the reflectors 40 are integrally formed of metal, such as aluminum, that has satisfactory thermal conductivity, and they are electrically insulated from the circuit pattern 11a via a sheet formed of silicon resin, epoxy resin or the like having electrical insulation and thermal conduction and are arranged in thermally close contact with the base body 11, the reflectors 40 can also function as a heat dissipation fin for dissipating heat from the LED chips 12.

Moreover, since 56 reflectors 40 formed integrally can easily be removed from the sprue runner 40b, it is possible to select whether or not the reflectors 40 are fitted to the space S of the base body 11 and to optionally and freely fit a required number of reflectors 40 to the spaces S in any positions to obtain various intended light distribution characteristics. In addition, in Figs. 8 to 10, the same parts as in Figs. 1 and 3 are identified with common symbols, and their detailed description will not be repeated.

In this embodiment, a transparent front surface cover is provided so as to cover the front surface opening portion 32a of the illumination device 30, and thus electrical components or the like in the light-emitting module 10 may be dust-resistant or water-resistant. A translucent light diffusion member having a milky white color or the like for further diffusing light may be provided according to illumination applications so as to cover the front surface opening portion 32a. These front surface cover and light diffusion member may be provided such that they are attachable and removable from the front surface opening portion 32a.

Fig. 11 shows another variation of the light-emitting module 10 using the above-described front surface cover. In this light-emitting module 10, the LED chips 12 arranged on the front surface of the base body 11 are covered with the sealing member 13 in the shape of a mountain, and a translucent front surface cover 50 is arranged over the front surface of the base body 11.

The front surface cover 50 is formed of synthetic resin having translucency; in the front surface cover 50, an accommodation recess portion 51 for accommodating the base body 11 is formed, and recessed portions 52 corresponding to the positions of the LED chips 12 and the sealing member 13 are formed in the inner surface of the accommodation recess portion 51 facing the base body 11. Between the inner surface of the accommodation recess portion 51 of the front surface cover 50 and the front surface of the base body 11, filling resin 53 is filled such that they are in close contact with each other without an air layer. This filling resin 53 is formed of a material that is the same as those of the sealing member 13 and the front surface cover 50 or that has slight variations in refractive index such that the interface between the sealing member 13 and the front surface cover 50 has slight variations in refractive index.

On the back side of the front surface cover 50, the base body 11 is accommodated in the accommodation recess portion 51, and thereafter a rear surface cover 54 is fitted.

In the light-emitting module 10 configured as described above, heat produced when the LED chips 12 are lit is effectively conducted via the sealing member 13, the filling resin 53 and the front surface cover 50 without an air layer being interposed, and can be effectively dissipated into the air from the front surface of the front surface cover 50. Thus, heat is sufficiently dissipated from the front surface of the light-emitting module 10, and hence the light-emitting module can be applied to, for example, an illumination device directly fitted to a ceiling that is likely to have low heat dissipation from the rear surface side.

Although the preferred embodiment of the present invention is described above, the present invention is not limited to the above-described embodiment, and many modifications are possible without departing from the spirit of the present invention.

## Claims

1. A light-emitting module comprising: a base body formed with a non-metallic member having a thermal conductivity of 1W/mk or less; a plurality of light-emitting diode chips spaced 10 to 30 mm apart from each other on a front surface of the base body, an electric power of 0.06 to 0.10 W being supplied to each of the chips; and a translucent sealing member covering an area between the adjacent light-emitting diode chips.

2. A light-emitting module according to claim 1 in which the translucent sealing member also covers the light-emitting diode chips.

3. A light-emitting module according to claim 1 or claim 2, wherein, between the adjacent light-emitting diode chips, the base body is provided with reflector means arranged to reflect light emitted from the light-emitting diode chips in a direction of the front surface, and the reflector means is covered with the translucent sealing member.

4. A light-emitting module according to claim 3 in which the reflector means comprises a plurality of generally conical reflectors arranged in the spaces between the light-emitting devices so that light emitted from the sides of the light-emitting devices are reflected forwards by the sloping sides of the reflectors.

5. A light-emitting module according to any one of the preceding claims, further comprising a translucent front surface cover arranged on the front surface of the sealing member without an air layer being interposed between the sealing member and the front surface cover.

6. An illumination device comprising: a light-emitting module according to any one of the preceding claims, an apparatus main body in which the light-emitting module is mounted; and a driver circuit for the light-emitting module.
